# EUROPÄISCHE PATENTSCHRIFT

(11) **EP 3 417 301 B1**
(45) Veröffentlichungstag und Bekanntmachung des Hinweises auf die Patenterteilung: **08.04.2020**
(21) Anmeldenummer: 17704258.7
(22) Anmeldetag: 10.02.2017
(51) Int. Cl.: G01R 31/327

(54) **PRÜFGERÄT ZUM PRÜFEN EINER STEUEREINHEIT EINER SCHALTVORRICHTUNG EINER SCHALTANLAGE**
TEST DEVICE FOR TESTING A CONTROL UNIT OF A SWITCHING APPARATUS OF A SWITCHGEAR
APPAREIL DE TEST POUR CONTRÔLER UNE UNITÉ DE COMMANDE D'UN DISPOSITIF DE COMMUTATION D'UN SYSTÈME DE COMMUTATION

(30) Priorität: 15.02.2016 AT 500932016
(43) Veröffentlichungstag der Anmeldung: 26.12.2018
(73) Patentinhaber: Omicron electronics GmbH, 6833 Klaus (AT)
(72) Erfinder: JOCHUM, Michael, 6844 Altach (AT); GEIGER, Stephan, 6830 Rankweil (AT); KÜNG, Rainer, 6741 Raggal (AT)
(74) Vertreter: Patentanwälte Pinter & Weiss OG
(86) Internationale Anmeldenummer: PCT/EP2017/052961
(87) Internationale Veröffentlichungsnummer: WO 2017/140582

(56) Entgegenhaltungen:
- AT-A1- 515 592
- DE-A1-102011 086 412
- DE-A1-102014 206 366
- GB-A- 2 034 997

## Beschreibung

Die gegenständliche Erfindung betrifft ein Prüfgerät und ein Verfahren zum Prüfen einer Steuereinheit einer Schaltvorrichtung einer Schaltanlage wobei das Prüfgerät einen Signaleingang aufweist. Ebenso betrifft die Erfindung die Verwendung des Prüfgeräts zum Prüfen einer Steuereinheit einer Schaltvorrichtung einer Schaltanlage.

Oftmals sind Geräte zur Prüfung von Steuereinheiten von elektrischen Schaltvorrichtungen notwendig. Speziell im Bereich der elektrischen Schutztechnik und elektrischen Energieversorgung ist die Prüfung der Funktion von Schaltvorrichtungen und deren Steuereinheiten wichtig und oftmals sogar vorgeschrieben. Beispielsweise sind in elektrischen Mittelspannungsnetzen an Masten montierte Schaltvorrichtungen oft mit elektro-magnetischen Aktuatoren ausgestattet und über Steuerverbindungen mit Steuereinheiten verbunden. Üblicherweise wird ein Prüfgerät verwendet, das die Schaltvorrichtung simulieren soll. Dazu wird die Schaltvorrichtung und die Steuerverbindung von der Steuereinheit getrennt und stattdessen ein Prüfgerät über ein Adapterkabel an die Steuereinheit angeschlossen, um deren Funktion zu prüfen. Das Prüfgerät muss dann entsprechende elektrische Signale erzeugen, die die Steuereinheit zu bestimmten Reaktionen anregen sollen. Die Reaktionen werden vom Prüfgerät erfasst und ausgewertet.

Steuereinheiten haben unter anderem die Funktion, über Steuerverbindungen kurzzeitig eine positive Spannung auf die Spule des Aktuators auszugeben und damit die Schaltvorrichtung zu öffnen. Zum Schließen der Schaltvorrichtung wird eine negative Spannung über die gleiche oder eine andere Steuerleitungen ausgegeben. Typischerweise werden Gleichspannungen im Bereich von 12-250V verwendet. Die Dauer der Spannungsimpulse liegt typischerweise im Bereich von 10ms bis 100ms und ist von der Ausgestaltung der Schaltvorrichtung abhängig. Um ein Schalten der Schaltvorrichtung zu ermöglichen, muss die Schaltvorrichtung, d.h. in erster Linie die angeschlossene Spule des magnetischen Aktuators, oftmals zuerst von der Steuereinheit erkannt werden, um beispielsweise eine defekte Steuerverbindung zu erkennen, bzw. um sicherzustellen, dass die Schaltvorrichtung angeschlossen ist. Diese Erkennung erfolgt über kurzzeitig ausgegebene Pulse durch die Steuereinheit, wobei die Pulse selbstverständlich so kurz sein müssen, dass die Schaltvorrichtung keine Schalthandlung auslöst. Durch Messung des rückfließenden Stroms wird auf die angeschlossene Last (also in erster Linie auf den Widerstand der Spule) geschlossen. Um den Zustand des Aktuators zu bestimmen, d.h. ob die Schaltvorrichtung betätigt oder nicht betätigt ist, ist es in manchen Steuereinheiten auch üblich, die Impedanz des magnetischen Aktuators kontinuierlich oder in Intervallen zu messen, da die Impedanz der Schaltvorrichtung vom Zustand des Aktuators abhängig ist.

Die Druckschrift AT 515 592 A1 offenbart beispielsweise ein Prüfgerät zum Prüfen einer Steuereinheit einer Schaltvorrichtung.

Es sind in der Regel Adapterkabel notwendig, um diese Steuerleitungen der Steuereinheit an den Messeingang eines Prüfgerätes anzuschließen. Diese Adapterkabel beinhalten oftmals eine zusätzliche Elektronik oder ein zusätzliche elektrische Beschaltung. Zumeist werden im Adapterkabel Widerstände verwendet, um die Impedanz der Spule des magnetischen Aktuators zu simulieren und damit der Steuereinheit eine angeschlossene Schaltvorrichtung zu suggerieren. Zudem sind in den Adapterkabeln Vorrichtungen notwendig, welche die an den Steuerleitungen anliegenden positiven und negativen Spannungen trennen und zu jeweils positiven Spannungen wandeln und separat (also über separate Leitungen) an das Prüfgerät weiterleiten. Diese entstehenden positiven Spannungen können also an das Prüfgerät an zwei unterschiedliche binäre Signaleingänge mit jeweils zwei Pins angelegt werden, woraufhin das Prüfgerät die Funktion der Steuereinheit prüfen kann.

Die bisher bekannte Lösung bedarf somit zusätzlicher Komponenten, um eine Prüfung der Steuereinheit zu ermöglichen. Die Herstellung von Adapterkabeln, die diese Komponenten beinhalten, wird dadurch komplexer, teurer und fehleranfällig. Weiters müssen unterschiedliche Adapterkabel mit unterschiedlichen elektrischen Eigenschaften verwendet werden, wenn Schaltvorrichtungen mit unterschiedlichen elektrischen Eigenschaften getestet werden. Außerdem müssen mehrere binäre Signaleingänge des Prüfgeräts belegt werden, was auch die eigentliche Verkabelung komplexer und fehleranfälliger macht.

Die Aufgabe der gegenständlichen Erfindung besteht somit darin, ausgehend vom oben beschriebenen Stand der Technik eine verbesserte Funktionsprüfung der Schaltvorrichtung durch ein Prüfgerät zu ermöglichen.

Diese Aufgabe wird gelöst, indem der Signaleingang des Prüfgeräts einen positiven Pin und einen negativen Pin aufweist und derart ausgelegt ist, dass ein Eingangssignal zwischen dem positiven Pin und dem negativen Pin angelegt werden kann. Weiters weist das Prüfgerät eine Trenneinheit auf, die mit dem positiven Pin und dem negativen Pin verbunden ist und ausgestaltet ist, vom Eingangssignal einen positiven Signalanteil in Form einer positiven Spur zu trennen und an einem ersten Pin auszugeben und vom Eingangssignal einen negativen Signalanteil in Form einer negative Spur zu trennen und an einem zweiten Pin auszugegeben.

Somit stellt das Prüfgerät einen ternären Signaleingang zur Verfügung. Im Unterschied zum herkömmlichen Binäreingang wird die Eingangsspannung im Prüfgerät mittels der Trenneinheit in eine positive und negative Spur aufgeteilt. Die erfindungsgemäße Lösung benötigt im Gegensatz zum Stand der Technik keine externen Komponenten, um das Signal in zwei Spuren aufzuteilen und belegt somit auch lediglich die halbe Anzahl von Eingängen am Prüfgerät. Die Erfindung erlaubt es, das Prüfgerät zur Prüfung der Steuerung mittels eines Adapterkabels direkt an die Steuerleitung anzuschließen, wobei das Adapterkabel keinerlei Elektronik aufweisen muss. Die Herstellung von Adapterkabeln wird dadurch günstiger und einfacher. Zudem wird das Risiko von Komponentenfehlern im Adapterkabel minimiert.

Das Prüfgerät kann somit zum Prüfen einer Steuereinheit einer Schaltvorrichtung einer Schaltanlage verwendet werden, indem das Prüfgerät die Schaltvorrichtung nachbildet. Der Signaleingang des Prüfgeräts wird mit der Steuereinheit verbunden und von der Steuereinheit wird ein Eingangssignal an den Signaleingang ausgegeben.

Vorteilhafterweise weist das Prüfgerät eine Logikeinheit auf, die mit dem ersten Pin und dem zweiten Pin verbunden ist und die positive Spur und die negative Spur unabhängig voneinander verarbeitet.

Ferner kann das Prüfgerät eine Vergleichseinheit aufweisen, die die positive Spur mit einer positiven Schwelle und die negative Spur mit einer negativen Schwelle vergleicht.

Ebenso kann das Prüfgerät das Prüfgerät eine Detektionseinheit aufweisen, die die positive und/oder negative Flanken der positiven Spur und/oder der negativen Spur detektiert.

Die Trenneinheit kann vorteilhafterweise durch einen Gleichrichter realisiert werden, wobei der erste Pin mit einem ersten Eingang des Gleichrichters und dem positiven Pin verbunden ist und der zweite Pin mit dem zweiten Eingang des Gleichrichters und dem negativen Pin verbunden ist.

Diese Realisierung ist besonders kostengünstig, da lediglich ein Vollweggleichrichter, d.h. in der Regel 4 Dioden benötigt werden. Es ist möglich den Gleichrichter im Leerlauf zu betreiben oder einen Eingangsstrom zu beziehen, welcher durch einen festen Wert repräsentiert, oder dynamisch einstellbar ist - je nach Notwendigkeit der Anwendung.

Weiter kann ein erster Analog/Digital-Wandler vorhanden ist, der mit dem ersten Pin verbunden ist und die positive Spur digitalisiert und/oder ein zweiter Analog/Digital-Wandler vorhanden ist, der mit dem zweiten Pin verbunden ist und die negative Spur digitalisiert.

Somit ist eine weitere Behandlung der positiven bzw. negativen Spur in Digitaler Form möglich, wodurch positive oder negative Schwellwerte, positive oder negative Flanken, usw. in einfacher Weise, beispielsweise in der Logikeinheit, analysiert und davon ausgehend Aktionen gesetzt werden können.

Der Signaleingang kann über digitale Eingangsfilter F verfügen, die beispielsweise eine Entstörung oder Entprellung von Eingangssignalen bewirken. So können Degitlich-Filter kurze Störimpulse ausfiltern oder Debounce-Filter das Eingangssignal entprellen. Die Parameter, wie z.B. Grenzfrequenzen, sowie Filterlaufzeiten wie Entprellzeiten oder Entstörzeiten der Filter können durch die vorteilhafte digitale Realisierung individuell je nach Anforderungen unterschiedlicher Schaltvorrichtungen eingestellt werden.

Die gegenständliche Erfindung wird nachfolgend unter Bezugnahme auf die Figuren 1 bis 3 näher erläutert, die beispielhaft, schematisch und nicht einschränkend vorteilhafte Ausgestaltungen der Erfindung zeigen. Dabei zeigt
Fig.1 einen Teil eines elektrischen Versorgungsnetzes,
Fig.2 das Versorgungsnetz mit getrennter Verbindung zwischen Schaltvorrichtung und Steuereinheit, die zur Prüfung an ein Prüfgerät angeschlossen ist, und
Fig.3 einen erfindungsgemäßen Schaltungsaufbau des Prüfgeräts.

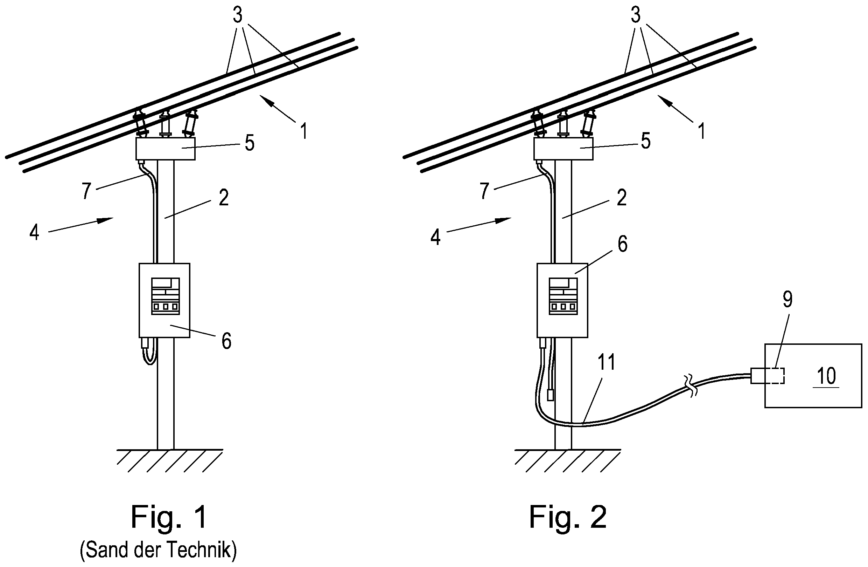

In Fig.1 ist ein Teil eines elektrischen Versorgungsnetzes 1 dargestellt, im gezeigten Ausführungsbeispiel eine 3-phasige Freileitung, deren Leitungen 3 in herkömmlicher Weise zwischen Masten 2 gespannt sind. Am Mast 2 ist als Sicherheitseinrichtung eine Schaltanlage 4 vorgesehen, die aus einer Schaltvorrichtung 5 und einer zugehörigen Steuereinheit 6 besteht. Die Schaltvorrichtung 5 ist beispielsweise in bekannter Weise ein Recloser oder ein Leistungsschalter in Form eines magnetischen Aktuators, der eine Spule beinhaltet. Die Schaltvorrichtung 5 ist in der Lage, durch eine von der Steuereinheit 6 ausgelöste Schalthandlung, zumindest eine der Leitungen 3 zu trennen oder zu verbinden. Die Erfindung ist aber natürlich nicht auf die Anwendung in einem elektrischen Versorgungsnetz 1 in Form einer Freileitung beschränkt, sondern kann in jeder Anlage zur Übertragung oder Verteilung von elektrischer Energie mit Sicherheitseinrichtungen in Form einer Schaltanlage 4 mit einer Schaltvorrichtung 5 und einer zugehörigen Steuereinheit 6 verwendet werden.

Die Schaltvorrichtung 5 ist hierzu mit einer Steuerverbindung 7 mit der Steuereinheit 6 verbunden. Die Steuerverbindung 7 umfasst hierzu in der Regel eine Anzahl von Steuerleitungen zur Übermittlung von Steuereingangsgrößen und Steuerausgangsgrößen. Durch Steuerausgangsgrößen werden typischerweise Schalthandlungen ausgelöst. Hier gibt es auf Seite der Steuereinheit 6, auf für jede Phase einzeln, oftmals separate Signalausgänge für ein Trip-Signal (also Öffnen der Schaltvorrichtung 5) und für ein Close-Signal (also Schließen der Schaltvorrichtung 5), es kann aber auch nur ein binärer Signaleingang für Trip und Close verwendet werden. Insbesondere relevant für die Erfindung sind dabei Steuerausgangsgrößen. Diese Steuerausgangsgrößen sind Signale, die von der Steuereinheit 6, z.B. in Reaktion auf die Steuereingangsgrößen, erzeugt werden und mit denen die Funktion der Schaltvorrichtung 5 gesteuert wird, beispielsweise eine Schalthandlung ausgelöst wird. Dabei wird beispielsweise von der Steuereinheit 6 als Steuerausgangsgröße über die Steuerleitungen 7 ein positiver Puls für das Trip-Signal, oder ein negativer Puls als Close-Signal ausgegeben.

Zum Prüfen der Schaltanlage 4 wird die Steuerverbindung 7 zwischen Schaltvorrichtung 5 und Steuereinheit 6 getrennt, wie in Fig.2 dargestellt. Es wäre auch möglich, dass die Schaltvorrichtung 5 vor der Prüfung gar nicht mit der Steuereinheit 6 verbunden ist, beispielsweise bei Erstinbetriebnahme. Dann würde das Trennen der Steuerverbindung 7 entfallen. Das ist recht häufig der Fall, da die Steuereinheiten 6 oft vor Installation parametriert und anschließend mit dem Prüfgerät 10 auf Funktion getestet werden, bevor diese "ins Feld" gebracht und installiert werden. Die Steuereinheit 6 wird zur Prüfung mit einem Adapterkabel 11 mit einem Prüfgerät 10 verbunden, das die Schaltvorrichtung 5 simuliert, um die ordnungsgemäße Funktion und Parametrierung der Steuereinheit 6 der Schaltanlage 4 prüfen zu können. Das Adapterkabel 11 wird mit einer Seite an den Signalausgang der Steuereinheit 6 und mit der anderen Seite an den Signaleingang 9 des Prüfgeräts 10 angeschlossen. Selbstverständlich können mit dem Adapterkabel 11 auch Signaleingänge der Steuereinheit 6 und Signalausgänge des Prüfgeräts 10 kontaktiert werden. Das Prüfgerät 10 dient somit dazu, die Schaltvorrichtung 5 nachzubilden bzw. zu simulieren.

Über den Signaleingang empfängt das Prüfgerät 10 Steuerausgangsgrößen der Steuereinheit 6, wobei Prüfgeräte 10 nach Stand der Technik in der Regel binäre Signaleingänge aufweisen. Das Prüfgerät 10 zur Nachbildung der Schaltvorrichtung 5 muss daher konfiguriert werden, um die in der Schaltvorrichtung 5 vorhandenen Signaleingänge und Signalausgänge nachbilden zu können. Wobei für eine Prüfung nicht unbedingt alle Signaleingänge oder Signalausgänge benötigt werden. Üblicherweise sind am Prüfgerät 10 je ein Signaleingang 9 für das Trip-Signal und je ein Signaleingang 9 für das Close-Signal vorhanden, wobei jeder Signaleingang 9 wiederum aus zwei Pins besteht. Hierzu wird in einer im Adapterkabel 11 untergebrachten Elektronik oder elektrischen Beschaltung das positive Steuersignal (z.B. Trip) oder negative Steuersignal (z.B. Close) aufgespalten und an jeweils einen binären Signaleingang 9 zugeführt. Dies kann jeweils als positives oder als negatives Steuersignal erfolgen, pro Signaleingang ist jedenfalls nur eine (positive oder negative) Schaltschwelle möglich. Dazu sind die Adapterkabel 11 üblicherweise mit Elektronik oder einer elektrischen Beschaltung versehen, was die Produktion der Adapterkabel 11 kostenintensiver macht und auch deren Robustheit negativ beeinflusst.

Zudem weist die Schaltvorrichtung 5 eine Impedanz auf, welche ebenso in der Elektronik bzw. der elektrischen Beschaltung des Adapterkabels 11, beispielsweise in Form von Widerständen, berücksichtigt werden muss. Somit sind für unterschiedliche Schaltvorrichtungen 5 mit unterschiedlichen Impedanzen unterschiedliche Adapterkabel 11 notwendig. Diese Impedanz ist beispielsweise bei Realisierung der Schaltvorrichtung 5 durch einen magnetisch betätigten Aktuator zudem abhängig von der Schalterstellung der Schaltvorrichtung 5. Das bedeutet, dass bei Simulierung der Schaltvorrichtung 5 durch das Prüfgerät 10 und das Adapterkabel 11 im laufenden Betrieb, sobald ein Schaltvorgang durch die Steuereinheit 6 ausgelöst wird, auch die veränderliche Impedanz durch das Prüfgerät 10 bzw. das Adapterkabel 11 berücksichtigt werden muss.

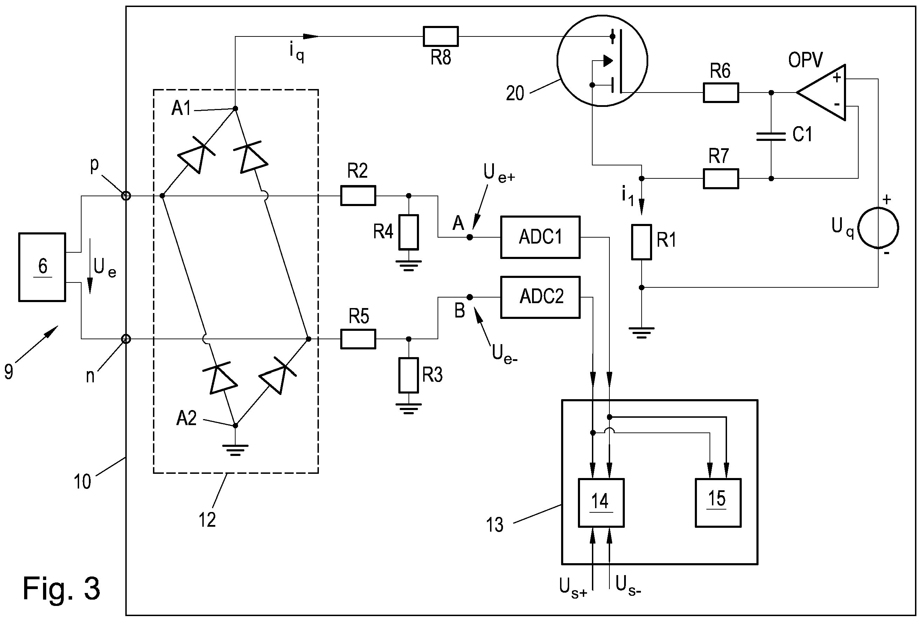

Erfindungsgemäß weist der Signaleingang 9 des Prüfgeräts 10 nun einen positiven Pin p und einen negativen Pin n auf und ist derart ausgelegt, dass ein Eingangssignal Uₑ zwischen dem positiven Pin p und dem negativen Pin n angelegt werden kann, wie in Fig.3 dargestellt. Weiter weist das Prüfgerät 10 eine Trenneinheit 12 auf, die mit dem positiven Pin p und dem negativen Pin n verbunden ist und ausgestaltet ist, vom Eingangssignal Uₑ einen positiven Signalanteil in Form einer positiven Spur Uₑ₊ zu trennen und an einem ersten Pin A auszugeben, bzw. intern zur Verfügung zu stellen, und vom Eingangssignal einen negativen Signalanteil in Form einer negative Spur Uₑ₋ zu trennen und an einem zweiten Pin B auszugegeben, bzw. intern zur Verfügung zu stellen.

Das erfindungsgemäße Prüfgerät 10 ermöglicht es somit, nur einen Signaleingang 9 für sowohl ein Trip-, als auch ein Close-Signal zu verwenden. Da der Signaleingang 9 ternär ausgestaltet ist, ist nur eine geringere Anzahl an Eingängen, als bei einer binären Ausgestaltung der Signaleingänge 9 notwendig.

Ein erfindungsgemäßes Prüfgerät 10 kann zum Prüfen einer Steuereinheit 6 einer Schaltvorrichtung 5 einer Schaltanlage 4 die Schaltvorrichtung 5 nachbilden, wobei der Signaleingang 9 des Prüfgeräts 10 mit der Steuereinheit 6 verbunden ist, z.B. über ein Adapterkabel 11, und von der Steuereinheit 6 ein Eingangssignal Uₑ an den Signaleingang 9 ausgegeben wird.

Weiters kann das Prüfgerät 10 eine Logikeinheit 13 aufweisen, die mit dem ersten Pin A und dem zweiten Pin B verbunden ist und die positive Spur Uₑ₊ und die negative Spur Uₑ₋ unabhängig voneinander verarbeitet.

Zudem kann das Prüfgerät 10 eine Vergleichseinheit 14 aufweisen, beispielsweise in der Logikeinheit 13, die die positive Spur Uₑ₊ mit einer vorgegebenen oder eingestellten positiven Schwelle U_{S+} und die negative Spur Uₑ₋ mit einer vorgegebenen oder eingestellten negativen Schwelle U_{S-} vergleicht.

Auch kann das Prüfgerät 10 eine Detektionseinheit 15, beispielsweise in der Logikeinheit 13, aufweisen, die die positive und/oder negative Flanken der positiven Spur Uₑ₊ und/oder der negativen Spur Uₑ₋ detektiert.

Ganz besonders vorteilhafte ist die Realisierung der Trenneinheit 12 durch einen Gleichrichter, wobei der erste Pin A mit einem ersten Eingangsanschluss des Gleichrichters und dem positiven Pin p verbunden ist und der zweite Pin B mit dem zweiten Eingangsanschluss des Gleichrichters und dem negativen Pin verbunden ist. Anders ausgedrückt fallen der erste Eingangsanschluss des Gleichrichters, der positive Pin p und der erste Pin A und der zweiten Eingangsanschluss des Gleichrichters, der negativen Pin und der zweite Pin B zusammen. Die Realisierung der Trenneinheit 12 in Form eines Gleichrichters bedeutet einen geringen schaltungstechnischen Aufwand.

Zudem kann ein erster Analog/Digital-Wandler ADC1 vorhanden sein, der mit dem ersten Pin A verbunden ist und die positive Spur Uₑ₊ digitalisiert und/oder ein zweiter Analog/DigitalWandler ADC2 vorhanden sein, der mit dem zweiten Pin B verbunden ist und die negative Spur Uₑ₋ digitalisiert. Das ermöglicht die digitale Verarbeitung der positive Spur Uₑ₊ und der negative Spur Uₑ₋ und die einfache Ausgestaltung der Vergleichseinheit 14 und der Detektionseinheit 15 als Software.

In Fig. 3 ist eine mögliche Ausgestaltung der Erfindung dargestellt. Am Signaleingang 9 liegt am positiven Pin p und am negativen Pin n eine Eingangsspannung Uₑ an, die von der Steuereinheit 6 über das Adapterkabel 11 geliefert wird. Eine Trenneinheit 12 ist beispielhaft in Form eines Gleichrichters mit dem positiven Pin p und dem negativen Pin n verbunden. Dabei sind der positive Pin p und der negativen Pin n mit der Eingangsseite des Gleichrichters verbunden.

Der Gleichrichter ist in der gezeigten Ausgestaltung als hinlänglich bekannter Brückengleichrichter mit Dioden ausgeführt, wobei auch andere Ausgestaltungen des Gleichrichters denkbar sind.

Durch den Abgriff des positiven Anteils der Eingangsspannung Uₑ am ersten Pin A des Gleichrichters, kann eine positive Spur Uₑ₊ der Eingangsspannung Uₑ abgetrennt werden. Durch den Abgriff des negativen Anteils der Eingangsspannung Uₑ am zweiten Pin B des Gleichrichters, kann eine negative Spur Uₑ₋ der Eingangsspannung Uₑ abgetrennt werden. Um die positive Spur Uₑ₊ und die negative Spur Uₑ₋ in Spannungen zu wandeln, die vom ersten Analog/Digital-Wandler ADC1 und vom zweiten Analog/Digital-Wandler ADC2 verarbeitet werden können, werden die positive Spur Uₑ₊ und die negative Spur Uₑ₋ jeweils mittels eines Spannungsteilers in Form der Widerstände R2 und R4, respektive R5 und R3 auf einen geringeren Spannungswert gewandelt. Die digitalisierten Werte der positiven Spur Uₑ₊ und der negativen Spur Uₑ₋ werden einer Logikeinheit 13 zugeführt, die in diesem Fall eine Vergleichseinheit 14 beinhaltet, und unabhängig voneinander verarbeitet. Die Vergleichseinheit 14 vergleicht die positive Spur Uₑ₊ bzw. die die negative Spur Uₑ₋ mit einer vorgegebenen positiven Schwelle U_{S+} bzw. einer vorgegebenen negativen Schwelle U_{S-}. Daraus kann auf ein durch die Steuereinheit 6 gesendetes Trip-, oder Close-Signal geschlossen werden. In der Logikeinheit 13 können digitale Filter realisiert werden. Ein großer Vorteil der digitalen Filterrealisierung sind die, im Betrieb je nach Anforderung unterschiedlich, einstellbaren Filterparameter. Es besteht natürlich auch die Möglichkeit analoge Filter vor den ADCs zu platzieren, jedoch mit dem Nachteil der fixen Parameter und des zusätzlichen Schaltungsaufwandes.

Die Realisierung der Trenneinheit 12 in Form eines Gleichrichters am Eingang hat schaltungstechnische Vorteile, da die Verwendung einer unipolaren Spannungsversorgung bzw. ADC Wandlung ermöglich wird und eine gesteuerte Stromquelle mittels eines MOSFET auf einfache Weise realisierbar ist.

Es wäre natürlich auch möglich den Signaleingang 9 bipolar ausführen und anschließend die positive Spur Uₑ₊ und die negative Spur Uₑ₋ in digitaler Weise aus der Eingangsspannung Uₑ zu erzeugen. Diese Lösung bringt jedoch gegenüber der zuvor geschilderten Ausgestaltung einige Nachteile mit sich: Die Realisierung der ADCs, insbesondere deren Spannungsversorgung ist aufwendiger und eine spannungsgesteuerte Stromquelle unter Verwendung nur einen MOSFET ist nicht möglich. Stattdessen wäre eine bipolare spannungsgesteuerte Stromquelle vonnöten, was schaltungstechnisch deutlich komplexer wäre. Eine mögliche Realisierung würde beispielsweise jeweils ein MOSFET mit n-Kanal und ein MOSFET mit p-Kanal umfassen. Diese Lösung ist somit nur in einer aufwendigen und komplexen Kabellösung realisierbar, da doppelt so viele (binäre) Eingänge und, wie erwähnt, zusätzlich einstellbare Impedanzen notwendig sind.

Der in Fig. 3 dargestellte Gleichrichter könnte auch mit hochohmig geschalteten Ausgangsanschlüssen A1, A2 des Gleichrichters betrieben werden, also beinahe im Leerlauf. Ein geschlossener Stromkreis muss jedoch in jedem Fall vorhanden sein, damit der Gleichrichter tatsächlich betrieben werden kann und somit die positiven und negativen Spuren getrennt werden können.

Um allerdings die Impedanz der Schaltvorrichtung 5 durch das Prüfgerät 10 in Form einer dynamisch einstellbaren Eingangsimpedanz Z des Prüfgeräts10 zu simulieren, kann im Prüfgerät 10 eine gesteuerte Stromsenke 20 vorhanden sein, die mit dem Signaleingang 9 verbunden ist, wobei die gesteuerte Stromsenke 20 vom Signaleingang 9 einen Eingangsstrom i_{q} abzweigt.

Ganz besonders vorteilhafterweise ist die gesteuerte Stromsenke 20 mittels eines gesteuerten Regelkreises realisiert, in dem eine gesteuerte Spannungsquelle U_{q} und ein auf ein Bezugspotential, z.B. Masse, gelegter Shunt R1 vorhanden sind. Die Höhe des Eingangsstroms I_{q} der gesteuerten Stromsenke 20 wird von einem über den Shunt R1 fließenden Strom i₁ eingestellt wird, wobei der Strom i₁ von der gesteuerten Spannungsquelle U_{q} eingestellt wird und in etwa dem Eingangsstrom i_{q} entspricht.

In Fig. 3 ist der Signaleingang 9 über die Trenneinheit 12, in diesem Fall der Gleichrichter, und den Widerstand R8, mit der gesteuerten Stromsenke 20, beispielsweise in Form eines n-Kanal-MOSFETS, verbunden. Der MOSFET als gesteuerte Stromsenke 20 bezieht über den Drain-Eingang von einem ersten Ausgang des Gleichrichters den Eingangsstrom i_{q}, welcher von der gesteuerten Spannungsquelle U_{q} eingestellt wird, der zweite Ausgang des Gleichrichters liegt auf Bezugspotential (hier Masse). Dazu ist die gesteuerte Spannungsquelle U_{q} mit dem nicht invertierenden Eingang eines OPV verbunden. Der invertierende Eingang des OVP ist über den Widerstand R7 mit dem ersten Anschluss des Shunts R1 verbunden, womit sich die Spannung der gesteuerten Spannungsquelle U_{q} am Shunt R1 einstellt, da der zweite Anschluss des Shunts R₁, sowie der negative Ausgang der Spannungsquelle U_{q} mit dem Bezugspotential (hier Masse) verbunden ist. Damit fließt über den Shunt R₁ ein Strom i₁, der in etwa dem über die gesteuerte Stromsenke 20 bezogenen Eingangsstrom i_{q} entspricht. Der erste Anschluss des Shunts R1 ist mit dem Source-Eingang S des MOSFET verbunden. Zwischen dem nicht invertierendem Eingang des OPV und dem Ausgang des OPVs ist ein Kondensator C1 geschaltet. Weiters ist der Ausgang des OPV über den Widerstand R6 mit dem Gate des MOSFET verbunden. Da der MOSFET vorzugsweise im Sättigungsbereich betrieben wird, wird der Eingangsstrom i_{q}, der dem Drainstrom des MOSFET entspricht, über die Drain-Source-Spannung, d.h. in weiterer Linie über die gesteuerte Spannungsquelle U_{q}, eingestellt.

Selbstverständlich kann die gesteuerte Stromsenke 20 alternativ auch beispielsweise mittels Bipolar Transistoren realisiert werden. Eine derartige Änderung der Ansteuerung würde jedoch eine verringerte Spannungsfestigkeit bedeuten

Der Eingangsschutzwiderstand R8 weist einen positiven Temperaturkoeffizienten auf. Bei zu großen Eingangsströmen dient der Eingangsschutzwiderstand R8 als reversible thermische Sicherung, d.h. der Wert des Eingangswiderstands R8 steigt mit erhöhtem Eingangsstrom iq womit die Stromsenke 20 vor Überströmen geschützt wird. Der Operationsverstärke OPV dient als P-Regler, wobei die am nicht invertierenden Eingang anliegende Eingangsspannung U_{q} am Shunt R1 ausgeregelt wird. Der Proportionalwiderstand R7 ergibt im Verhältnis zu R1 den proportional Anteil des durch die OPV -Schaltung realisierten P-Reglers. Der sich dabei einstellende Strom am Ausgang des Operationsverstärkers OPV ergibt sich aus dem Quotienten von Eingangsspannung U_{q} am nicht invertierenden Eingang des OPV und dem Widerstand des Shunts R1. Der Kondensator C1 dient der Stabilität des Reglers, indem er bei höheren Frequenzen die Verstärkung reduziert. Der Gate-Widerstand R6 dient zur Ansteuerung des MOSFET.

Ein erfindungsgemäßes Prüfgerät 10 kann somit dazu verwendet werden, die Eingangsimpedanz Z durch den einstellbaren Eingangsstrom i_{q} und die anliegende Eingangsspannung Uₑ einzustellen.

Dazu kann die gesteuerte Stromsenke 20 oder die die gesteuerte Stromsenke 20 steuernde gesteuerte Spannungsquelle U_{q} softwaremäßig angesteuert werden. Damit kann der vom Signaleingang 9 abgezweigte Eingangsstrom i_{q} eingestellt werden, der in Kombination mit der Eingangsspannung Uₑ die gewünschte Eingangsimpedanz Z ergibt. Die dynamisch einstellbare Eingangsimpedanz Z ermöglicht einerseits eine Simulation diverser Schaltvorrichtungen 5 mit einem Prüfgerät 10 ohne die Notwendigkeit unterschiedlicher Adapterkabel 11 (abgesehen von eventuell unterschiedlichen Steckverbindungen). Weiters kann eine vom Schaltzustand abhängige Impedanz der Schaltvorrichtung 5 berücksichtigt werden, da im laufenden Betrieb/Test des Prüfgeräts 10 die Eingangsimpedanz Z beliebig variiert werden kann.

## Patentansprüche

1. Prüfgerät zum Prüfen einer Steuereinheit (6) einer Schaltvorrichtung (5) einer elektrischen Schaltanlage (4), wobei das Prüfgerät (10) einen Signaleingang (9) aufweist, **dadurch gekennzeichnet, dass** der Signaleingang (9) einen positiven Pin (p) und einen negativen Pin (n) aufweist und derart ausgelegt ist, dass ein Eingangssignal (Uₑ) zwischen dem positiven Pin (p) und dem negativen Pin (n) anlegbar ist, **dass** das Prüfgerät (10) eine Trenneinheit (12) aufweist, die mit dem positiven Pin (p) und dem negativen Pin (n) verbunden ist und ausgestaltet ist, vom Eingangssignal (Uₑ) einen positiven Signalanteil in Form einer positiven Spur (Uₑ₊) zu trennen und an einem ersten Pin (A) auszugeben und vom Eingangssignal einen negativen Signalanteil in Form einer negative Spur (Uₑ₋) zu trennen und an einem zweiten Pin (B) auszugegeben.

2. Prüfgerät nach Anspruch 1, **dadurch gekennzeichnet dass** das Prüfgerät eine Logikeinheit (13) aufweist, die mit dem ersten Pin (A) und dem zweiten Pin (B) verbunden ist und die positive Spur (Uₑ₊) und die negative Spur (Uₑ₋) unabhängig voneinander verarbeitet.

3. Prüfgerät nach Anspruch 1 oder 2, **dadurch gekennzeichnet dass,** das Prüfgerät eine Vergleichseinheit (14) aufweist, die die positive Spur (Uₑ₊) mit einer positiven Schwelle (U_{S+}) und die negative Spur (Uₑ₋) mit einer negativen Schwelle (U_{S-}) vergleicht.

4. Prüfgerät nach einem der Ansprüche 1 bis 3, **dadurch gekennzeichnet dass** das Prüfgerät eine Detektionseinheit (15) aufweist, die die positive und/oder negative Flanken der positiven Spur (Uₑ₊) und/oder der negativen Spur (Uₑ₋) detektiert.

5. Prüfgerät nach einem der Ansprüche 1 bis 4, **dadurch gekennzeichnet, dass** die Trenneinheit (12) durch einen Gleichrichter realisiert ist, wobei der erste Pin (A) mit einem ersten Eingang des Gleichrichters und dem positiven Pin (p) verbunden ist und der zweite Pin (B) mit dem zweiten Eingang des Gleichrichters und dem negativen Pin verbunden ist.

6. Prüfgerät nach einem der Ansprüche 1 bis 5, **dadurch gekennzeichnet, dass** ein erster Analog/Digital-Wandler (ADC1) vorhanden ist, der mit dem ersten Pin (A) verbunden ist und die positive Spur (Uₑ₊) digitalisiert und/oder ein zweiter Analog/Digital-Wandler (ADC2) vorhanden ist, der mit dem zweiten Pin (B) verbunden ist und die negative Spur (Uₑ digitalisiert.

7. Prüfgerät nach einem der Ansprüche 1 bis 6, **dadurch gekennzeichnet, dass** ein Eingangsfilter vorhanden ist, der digital realisiert ist.

8. Verwendung eines Prüfgeräts nach einem der Ansprüche 1 bis 7, **dadurch gekennzeichnet, dass** zum Prüfen einer Steuereinheit (6) einer Schaltvorrichtung (5) einer Schaltanlage (4) das Prüfgerät (10) die Schaltvorrichtung (5) nachbildet, der Signaleingang (9) des Prüfgeräts mit der Steuereinheit (6) verbunden ist und von der Steuereinheit (6) ein Eingangssignal (Uₑ) an den Signaleingang (9) ausgegeben wird.

## Claims

1. A testing device for testing a control unit (6) of a switching device (5) of an electrical switchgear (4), wherein the test device (10) has a signal input (9), **characterized in that** the signal input (9) has a positive pin (p) and a negative pin (n) and is designed in such a manner that an input signal (Uₑ) may be applied between the positive pin (p) and the negative pin (n), **that** the test device (10) has a separation unit (12) which is connected to the positive pin (p) and to the negative pin (n) and is configured to separate a positive signal component in the form of a positive track (Uₑ₊) from the input signal (Uₑ) and to output said positive signal component at a first pin (A) and to separate a negative signal component in the form of a negative track (Uₑ₋) from the input signal and to output said negative signal component at a second pin (B).

2. The testing device of claim 1, **characterized in that** the testing device has a logic unit (13), which is connected to the first pin (A) and to the second pin (B) and which processes the positive track (Uₑ₊) and the negative track (Uₑ₋) independently from each other.

3. The testing device of claim 1 or 2, **characterized in that** the testing device has a comparator unit (14), which compares the positive track (Uₑ₊) to a positive threshold (Us+) and the negative track (Uₑ₋) to a negative threshold (U_{S-}).

4. The testing device of any of claims 1 to 3, **characterized in that** the testing device has a detection unit (15), which detects the positive and/or negative edges of the positive track (Uₑ₊) and/or of the negative track (Uₑ₋).

5. The testing device of any of claims 1 to 4, **characterized in that** the separation unit (12) is formed by a rectifier, wherein the first pin (A) is connected to a first input of the rectifier and to the positive pin (p) and the second pin (B) is connected to the second input of the rectifier and to the negative pin.

6. The testing device of any of claims 1 to 5, **characterized in that** a first analog/digital converter (ADC1) is provided, which is connected to the first pin (A) and which digitalizes the positive track (Uₑ₊) and/or a second analog/digital converter (ADC2) is provided, which is connected to the second pin (B) and which digitalizes the negative track (Uₑ₋).

7. The testing device of any of claims 1 to 6, **characterized in that** an input filter is provided, which is of the digital type.

8. Use of a testing device of any of claims 1 to 7, **characterized in that** for testing a control unit (6) of a switching device (5) of a switchgear installation (4), the testing device (10) reproduces the switching device (5), the signal input (9) of the testing device is connected to the control unit (6) and the control unit (6) outputs an input signal (Uₑ) to the signal input (9).

## Revendications

1. Appareil de contrôle destiné à contrôler une unité de commande (6) d'un dispositif de commutation (5) d'un système de commutation électrique (4), l'appareil de contrôle (10) comprenant une entrée de signal (9), **caractérisé en ce que** l'entrée de signal (9) comprend une broche positive (p) et une broche négative (n) et est conçue de sorte qu'un signal d'entrée (Uₑ) puisse être appliqué entre la broche positive (p) et la broche négative (n), **en ce que** l'appareil de contrôle (10) comprend une unité de séparation (12) qui est connectée à la broche positive (p) et à la broche négative (n) et qui est configurée pour séparer, du signal d'entrée (Uₑ), une composante de signal positive sous la forme d'une piste positive (Uₑ₊) et pour l'émettre vers une première broche (A), et pour séparer, du signal d'entrée, une composante de signal négative sous la forme d'une piste négative (Uₑ₋) et pour l'émettre vers une seconde broche (B).

2. Appareil de contrôle selon la revendication 1,
**caractérisé en ce qu'**il comprend une unité logique (13), laquelle est connectée à la première broche (A) et à la seconde broche (B) et traite la piste positive (Uₑ₊) et la piste négative (Uₑ₋) indépendamment l'une de l'autre.

3. Appareil de contrôle selon la revendication 1 ou 2,
**caractérisé en ce qu'**il comprend une unité de comparaison (14), laquelle compare la piste positive (Uₑ₊) avec un seuil positif (Uₛ₊) et la piste négative (Uₑ₋) avec un seuil négatif (Uₛ₋).

4. Appareil de contrôle selon l'une des revendications 1 à 3, **caractérisé en ce qu'**il comprend une unité de détection (15), laquelle détecte les flancs positifs et/ou négatifs de la piste positive (Uₑ₊) et/ou de la piste négative (Uₑ₋).

5. Appareil de contrôle selon l'une des revendications 1 à 4, **caractérisé en ce que** l'unité de séparation (12) est réalisée par un redresseur, la première broche (A) étant connectée à une première entrée du redresseur et à la broche positive (p), et la seconde broche (B) étant connectée à la seconde entrée du redresseur et à la broche négative.

6. Appareil de contrôle selon l'une des revendications 1 à 5, **caractérisé en ce qu'**un premier convertisseur analogique/numérique (ADC1) est prévu, lequel est connecté à la première broche (A) et numérise la piste positive (Uₑ₊), et/ou **en ce qu'**un second convertisseur analogique/numérique (ADC2) est prévu, lequel est connecté à la seconde broche (B) et numérise la piste négative (Uₑ).

7. Appareil de contrôle selon l'une des revendications 1 à 6, **caractérisé en ce qu'**un filtre d'entrée est prévu, lequel est réalisé numériquement.

8. Utilisation d'un appareil de contrôle selon l'une des revendications 1 à 7, **caractérisé en ce que,** pour le contrôle d'une unité de commande (6) d'un dispositif de commutation (5) d'un système de commutation (4), l'appareil de contrôle (10) reproduit le dispositif de commutation (5), l'entrée de signal (9) de l'appareil de contrôle est connectée à l'unité de commande (6) et un signal d'entrée (Uₑ) est émis vers l'entrée de signal (9) par l'unité de commande (6).
